Europäisches Patentamt

European Patent Office

Office européen des brevets

(11) Publication number: 0 437 704 A2

# EUROPEAN PATENT APPLICATION

(21) Application number: 90122357.8

(22) Date of filing: 23.11.90

(51) Int. Cl.⁵: **C23C  16/26**, C30B 29/04,
C23C 16/50, C23C 16/54

(30) Priority: 25.11.89 JP 305339/89
15.06.90 JP 155094/90

(43) Date of publication of application:
24.07.91 Bulletin  91/30

(84) Designated Contracting States:
BE CH DE FR GB IT LI NL SE

(71) Applicant: IDEMITSU PETROCHEMICAL CO.
LTD.
1-1, Marunouchi 3-chome Chiyoda-ku
Tokyo 100(JP)

(72) Inventor: Hayashi,Nariyuki,c/o Idemitsu
Petrochem.Co.Ltd.
1-1,Marunouchi 3-chome
Chiyoda-ku, Tokyo(JP)
Inventor: Katsumata,Satoshi,c/o Idemitsu
Petrochem.Co.Ltd.
1660,Kamiizumi,Sodegaura-cho
Kimitsu-gun, Chiba-ken(JP)

(74) Representative: Hoeger, Stellrecht & Partner
Uhlandstrasse 14 c
W-7000 Stuttgart 1(DE)

(54) Process for synthesizing diamond and diamond synthesis apparatus.

(57) Disclosed is a process for synthesizing high quality diamond, at high speed, in a gas phase using carbon monoxide and hydrogen gas as starting gases, which comprises adding an oxygen-containing inorganic gas such as $CO_2$ under conditions where graphite is produced unless the oxygen-containing inorganic gas is added. Also, disclosed is a process for consecutively synthesizing diamond on a plurality of substrates, which comprises placing a plurality of substrates (6) in a pre-chamber (4), moving each of the substrates into a reaction section (2), synthesizing diamond on the substrate, and then returning the substrate with a diamond film formed thereon to the pre-chamber. An apparatus adapted to practice the synthesis process is further disclosed.

FIG.6

## PROCESS FOR SYNTHESIZING DIAMOND AND DIAMOND SYNTHESIS APPARATUS

## BACKGROUND OF THE INVENTION

### 1. Field of the Invention

The present invention relates to a process for synthesizing diamond in a gas phase using carbon monoxide and hydrogen gas as starting materials.

Further, the present invention relates to a process for synthesizing diamond on a plurality of substrates without opening the reaction system, which makes it possible to improve productivity and quality of the resultant diamond films, and also relates to an apparatus which can be used in the practice of such process.

### 2. Related Art

Diamond is superior in hardness, electric properties, thermal conductivity, chemical stability and the like. Thus, it has been expected that such diamond can be used in a wide variety of fields, for example, as a coating material for various tools, an anti-abrasion material, a grinding material, an electrical material, a luminous body, an optical material, a material for a speaker, and the like.

Currently, a high pressure process is mainly adopted as a process for synthesis of diamond. However, recently, a low pressure gas phase process has attracted attention, and thus has been intensively studied. In the low pressure gas-phase process, it would be highly desired to increase the diamond production rate.

From the above view points, several studies have been made, and as a result, it has been found that according to the studies on the kinds of starting gases, the use of carbon precursor gas, particularly carbon monoxide as starting gas results in the increase in the diamond formation rate as compared to a conventional process. However, the higher concentration of the carbon precursor gas to accelerate the formation of diamond results in lower crystallinity of the diamond to be formed, increase in the amount of non-diamond components such as graphite and amorphous carbon, thereby leading to low quality of the diamond film.

Recently, a process for synthesis of diamond has been developed which comprises adding an oxygen-containing compound to starting gases consisting of a carbon precursor gas and hydrogen gas. Such a process is disclosed in, for example, Japanese Patent Application Laid-Open Gazettes (KOKAI) Sho 61-158,899 and Hei 1-197,391. However, the process using specific starting gases has following disadvantages.

KOKAI Sho 61-158,899 discloses a technique to utilize, as stating gas, at least a hydrocarbon gas and an oxygen-containing gas such as oxygen, carbon monoxide and carbon dioxide. However, it is known that the use of the hydrocarbon-containing gas results in low quality of the diamond film. In order to obtain high quality diamond, it is required to keep the hydrocarbon gas content to 3 vol. % or less. Thus, in this process, process conditions are so limited to obtain high quality diamond, and the diamond formation rate is not high enough.

KOKAI Hei 1-197,391 discloses a technique to add an oxygen-containing compound other than carbon monoxide and carbon dioxide, such as oxygen and water to starting gases consisting of carbon monoxide gas and hydrogen gas. However, this publication does not specifically mention the details of the synthesis conditions, although this process can produce diamond much faster than a conventional process.

On the other hand, in a gas phase process for synthesis of diamond such as a microwave plasma method, a batch process has been heretofore adopted. In the conventional batch process, after each diamond synthesis has been carried out, several steps are required, comprising stopping supply of starting gases and irradiation of microwave, resuming reduced pressure to normal pressure, taking out a finished substrate, and placing a next substrate.

It was found that in consideration of the processing time as a whole, factors other than the synthesis rate, i.e., time used for placing and displacing of substrates in or out of a reaction section should not be ignored because of relatively large time occupied in the whole processing time.

As described above, the conventional batch process for synthesizing diamond on a substrate has a disadvantage in that the processing time is long due to the adoption of the batch process, resulting in the low productivity. Also, this process has disadvantages in that it is difficult to improve the quality of the resultant diamond film and to automate the process since opening and closing of the reaction system is required each time for exchanging a substrate, resulting in the incorporation of impurities.

## SUMMARY OF THE INVENTION

An object of the present invention is to provide a process for synthesis of diamond having high crystallinity and high quality at high synthesis rate.

Another object of the present invention is to provide a process for synthesizing diamond capable of consecutively synthesizing diamond on a plurality of substrates without opening the reaction system.

Another object of the present invention is to provide an apparatus which can be used in the practice of the above process and which makes it possible to automate the diamond synthesis, resulting in reduction of labor.

Accordingly, there is now provided a process for synthesizing diamond in a gas phase using carbon monoxide and hydrogen gas as starting gases, which comprises adding an oxygen-containing inorganic gas other than carbon monoxide to the starting gases and conducting synthesis of diamond under conditions where graphite is produced unless the oxygen-containing inorganic gas is added. Preferably, the oxygen-containing inorganic gas is carbon dioxide. The carbon dioxide is preferably added in amount of 0.2 to 10 Vol.%, more preferably 0.3 to 5 Vol.% based on the amount of the carbon monoxide. The diamond synthesis is preferably carried out under conditions where a substrate temperature is calculated from the following equation:

The substrate temperature $\geq [1000 - (CO\%) \times 1.3]°C$

and a carbon monoxide content is at least 10 Vol.%, preferably 20 Vol.% based on the total amount of the starting gasses.

Another embodiment of the present invention is a process for synthesizing diamond which comprises placing a plurality of substrates in a pre-chamber which is in communication with a reaction section, moving each of the substrates to the reaction section, synthesizing diamond on the substrate and then returning the substrate with synthesized diamond formed thereon to the pre-chamber.

A still another embodiment of the present invention is a diamond synthesis apparatus comprising a reaction section, a pre-chamber which is in communication with the reaction section, a substrate holding section disposed in the pre-chamber for placing a plurality of substrates thereon and moving the substrates to a predetermined position from one to another, a means for moving each of the substrates between the predetermined position in the pre-chamber and a synthesis reaction position in the reaction section. Preferably, the apparatus is a microwave plasma apparatus.

Other objects of the present invention will be apparent from the following description and drawings.

## BRIEF DESCRIPTION OF THE DRAWINGS

Fig. 1 is a graph showing the conditions for forming graphite;

Fig. 2 to 5 are spectrum charts showing the Raman spectrum obtained in Example 1, Comparative Examples 1 and 2, Examples 2 and 3, respectively;

Fig. 6 is a schematic view of the apparatus for synthesis of diamond according to one of the embodiments of the present invention;

Fig. 7 is a top plan view of the substrate holder as shown in Fig. 6;

Fig. 8 is a top plan view showing another embodiment of a substrate holder; and

Fig. 9 is an enlarged side view, partly in section, of the apparatus of Fig. 7.

## DESCRIPTION OF THE PREFERRED EMBODIMENTS

On of the embodiment of the present invention is a process for synthesizing diamond in a gas phase using carbon monoxide and hydrogen gas as starting gases, which comprises adding an oxygen-containing inorganic gas other than carbon monoxide to the starting gases and conducting synthesis of diamond under conditions where graphite is produced unless the oxygen-containing inorganic gas is added. Such a process will be described in more detail as follows.

This diamond synthesis is not limited to any specific method as far as crystalline diamond can be formed in the gas phase. The diamond synthesis method includes, for example, a DC or AC arc discharge plasma method, a high frequency induced discharge method, a microwave discharge method (including magnetic filed-CVD method and ECR method), a method utilizing optical energy, an ion beam method which comprises inducing ions in an electric field in an ion chamber or by an ion gun, a thermal decomposition method which using a thermo-filament (including EACVD method), a burned flame method and a sputtering method.

3

Particularly, suitable methods include a microwave plasma CVD method and a magneto-microwave CVD method. In the microwave plasma CVD method, diamond is formed on a substrate by activating a mixed gas consisting of a carbon monoxide gas, a hydrogen gas and an oxygen-containing inorganic gas, by the formation of plasma caused by irradiation of microwave, and contacting the activated mixed gas with a substrate. In the magneto-microwave CVD method, diamond is grown on a substrate by generating a dense and stabilized plasma in a large area of microwave absorbing band area generated in an emanated magnetic field.

The substrates which can be used in the present invention include, for example, transparent substrates made of glass, sapphire and the like; metal substrates made of silicon, manganese, vanadium, thallium, aluminum, titanium, tungsten, molybdenum, germanium, chromium and the like; substrates made of oxide, nitride, boride and carbide of the above metals such as $SiC$, $Al_2O_3$, $Si_3N_4$ and sialon; substrates made of sintered carbide or super hard alloys such as WC-Co based hard alloy; substrates made of cermets such as $Al_2O_3$-Fe based one, TiC-Ni based one, Tic-Co based one and $B_4C$-Fe based one; and substrates made of various ceramics. In the case of using the transparent substrates, preferred are substrates having good transparency in a visible region and good surface flatness.

If a substrate is subjected to a flaw treatment by means of a supersonic treatment using a medium containing grinder particles, dispersed therein, having a particle size of 100 micrometers or less, which are made of particles of diamond, silicon carbide, cubic-boron nitride and the like, a diamond film can be readily formed on the treated substrate. Further, if the substrate surface is subjected to a miler surface treatment, diamond particles can be readily formed on the treated substrate.

The temperature of the substrate surface cannot be readily determined because of the differences in an activating method of the starting gases, but generally ranges from 400 to 1,200 °C, preferably from 600 to 1,150°C, more preferably from 800 to 1,100°C.

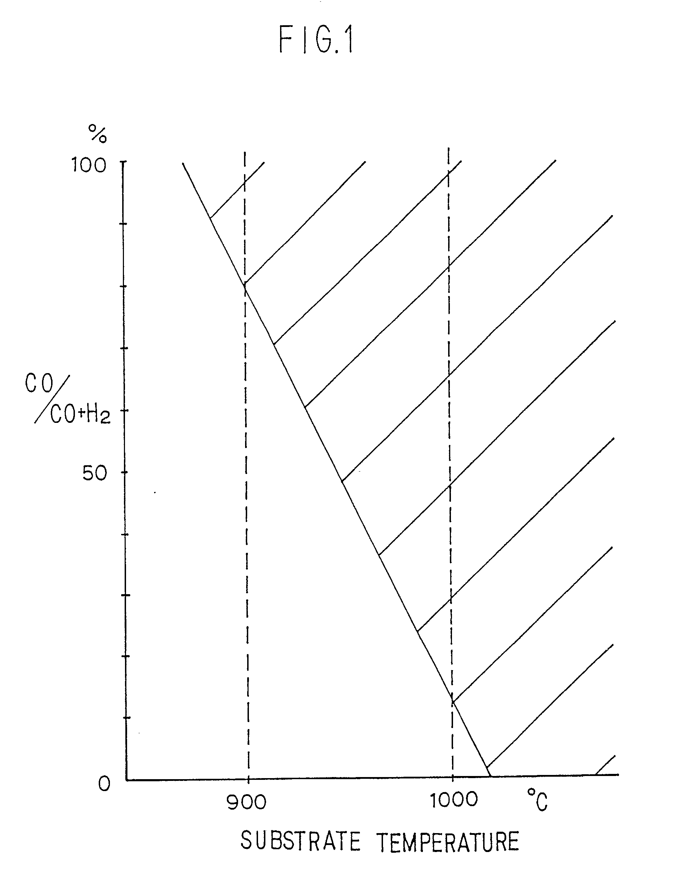

The substrate temperature can be preferably determined depending upon a carbon monoxide to hydrogen gas ratio in accordance with the graphite formation data as shown in Fig. 1, and can be calculated using the following equation:
The substrate temperature = [1000 - (CO%) X 1.3]°C.

With the temperature below 850°C, the diamond formation rate will become low; and the resultant product will contain non-diamond components and have lower crystallinity, resulting in poor purity and uniformity of the resultant product. With the temperature above 1,200°C, no specific advantage cannot be expected; sometimes diamond cannot be formed; and it is also disadvantageous in view of energy efficiency.

The starting gases which can be used in the present invention include carbon monoxide, hydrogen gas and an oxygen-containing inorganic gas. In this case, a carbon monoxide to hydrogen gas ratio, in volume, may be 10:90 to 98:2, preferably 20:80 to 80:20, more preferably 40:60 to 70:30. If the carbon monoxide content is greater than the above, the crystallinity and film quality of the resultant diamond will become poor. If the carbon monoxide content is less than the above ratio, the diamond formation rate will become low.

The suitable oxygen-containing inorganic gas other than carbon monoxide, which is added to carbon monoxide and hydrogen gas under the conditions where graphite is produced, includes, for example, carbon dioxide, oxygen, water, hydrogen peroxide, nitrogen dioxide, nitrogen monoxide and dinitrogen oxide. Among these, preferred is carbon dioxide in view of easiness of condition control during the diamond synthesis.

The amount of the oxygen-containing inorganic gas may vary depending upon the kinds of the gas used, but, in the case of using carbon dioxide, may range from 0.2 to 10 Vol.%, preferably from 0.3 to 5 Vol.% based on the amount of carbon monoxide used. The carbon dioxide content higher than the above ratio results in the decrease in the film formation rate and sometimes in failure of the film formation. The reasons for this are not clear, but it is considered that the amount cf precursor would reduce. For example, when the starting gas volume ratio of $CO:H_2:CO_2$ was 50:50:6, no diamond formation occurred. With the carbon dioxide content higher than the above ratio, no specific advantages can be expected.

The reaction time may vary and may be determined depending upon various factors such as the concentration of the starting gases, the kinds of the substrates used, the temperature of the substrate surface, the reaction pressure, the desired thickness of the resultant diamond film or the desired particle size of the resultant diamond particle.

The thickness of the resultant diamond film may range from 0.1 to 1,000 micrometers, preferably from 0.2 to 100 micrometers, more preferably from 0.3 to 50 micrometers. If the film is too thin, the film cannot completely cover the substrate, whereas if the film is too thick, the film is likely to come off.

The diamond synthesis according to the present invention can be carried out, for example, by placing a substrate on a substrate support made of quartz in a reaction section, irradiating microwave to the starting gases introduced into the reactor at a pressure of $10^{-6}$ to $10^3$ Torr.

In this case, it is possible to separately conduct synthesis of diamond, and placing and displacing of substrates, utilizing at least two closable pre-chambers positioned adjacent to a reactor section in order to consecutively synthesize diamond.

Further, it is possible to effectively synthesize diamond by utilizing a pre-chamber which is in communication with a reaction section. In this case, a plurality of substrates are placed in the pre-chamber, and each substrate is moved from one to another to a plasma area in the reaction section with the atmosphere of the reaction section being kept substantially unchanged. The use of such apparatus allows the consecutive diamond synthesis.

In addition, this diamond synthesis method is not limited to the above embodiments, but can be applicable to any, gas phase methods of synthesizing diamond.

The diamond synthesis methods of the present invention using an oxygen-containing inorganic gas will be described in more detail with reference to non-limitative Examples 1 to 3, Comparative Examples 1 and 2, and Reference Example 1.

## EXAMPLE 1

The synthesis of diamond was performed in accordance with the following conditions.

| (CONDITIONS) | | | |
|---|---|---|---|
| Starting Gas: | Flow Rate | 100 SCCM | |
| | Components | $CO$<br>$H_2$<br>$CO_2$ | 50 Vol.%<br>40 Vol.%<br>1 Vol.% |
| Substrate: | Silicon Nitride Type Cutting Tool | | |
| | Surface Temperature 1000°C | | |
| Reaction Pressure:<br>Reaction Time: | 40 Torr<br>5 hours | | |
| Synthesis Method: | Microwave Plasma CVD Method | | |
| | (Output: 400W, Microwave Frequency: 2.45GHz) | | |

The film thickness, the Raman spectrum and the film quality of the resultant product are as shown in Table 1. In view of the results of the Raman spectrum obtained, the resultant diamond had better quality as compared to the following Reference Example 1, and the film thickness was greater than any other films obtained in the experiments.

## COMPARATIVE EXAMPLE 1

Diamond was produced following the procedures of Example 1 except that the starting gas volume ratio of $CO:H_2:CO_2$ was changed to 60:40:0.

The film thickness, the Raman spectrum and the film quality of the resultant product areas shown in Table 1. In the resultant product, the graphite was formed since $CO_2$ was not added.

## COMPARATIVE EXAMPLE 2

Diamond was produced following the procedures of Example 1 except that the starting gas volume ratio of $CO:H_2:CO_2$ was changed to 15:85:0.

The film thickness, the Raman spectrum and the film quality of the resultant product are as shown in Table 1. In the resultant product, the crystallinity was somewhat poor due to a low CO concentration of 15%.

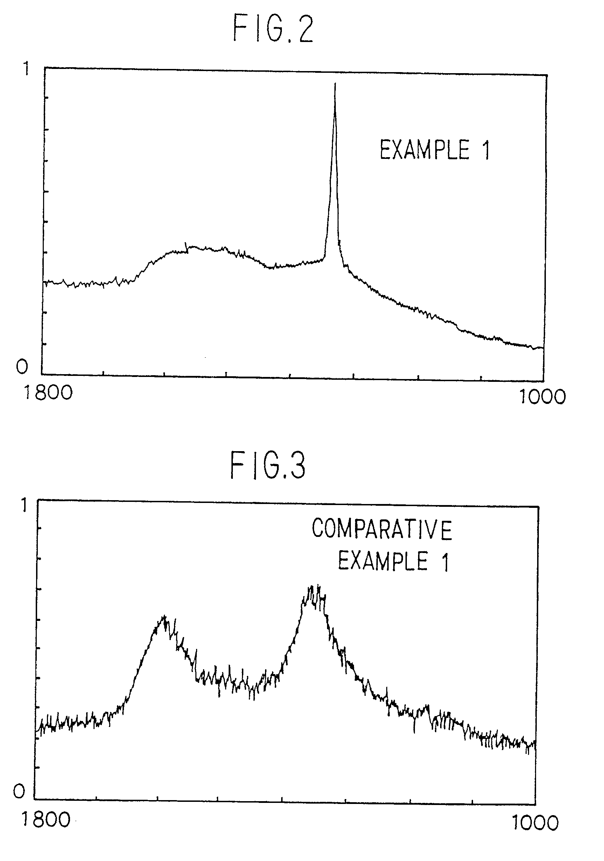

The Raman spectrum charts obtained in Example 1, and Comparative Examples 1 and 2 are as shown in Figs. 2 to 4.

REFERENCE EXAMPLE 1

Diamond was produced following the procedures of Example 1 except that the starting gas volume ratio of $CO:H_2:CO_2$ was changed to 7:93:0 and that the substrate temperature was changed to 900°C.

The film thickness, the Raman spectrum and the film quality of the resultant product are as shown in Table 1. In the resultant product, the film quality was good, but worse than that of Example 1. Also, the film was too thin.

Table 1

| Ex. No. | Film Thickness ($\mu$m) | Raman Spectrum | Film Quality |
|---------|------------------------|----------------|--------------|
| Ex. 1 | 16 | Excellent | Excellent |
| Comp. Ex. 1 | 11 | High peak for graphite | Graphites |
| Comp. Ex. 2 | 10 | Coexistence of Diamond and amorphous | Good |
| Ref. Ex. 1 | 5 | Good | Good |

EXAMPLE 2 and 3

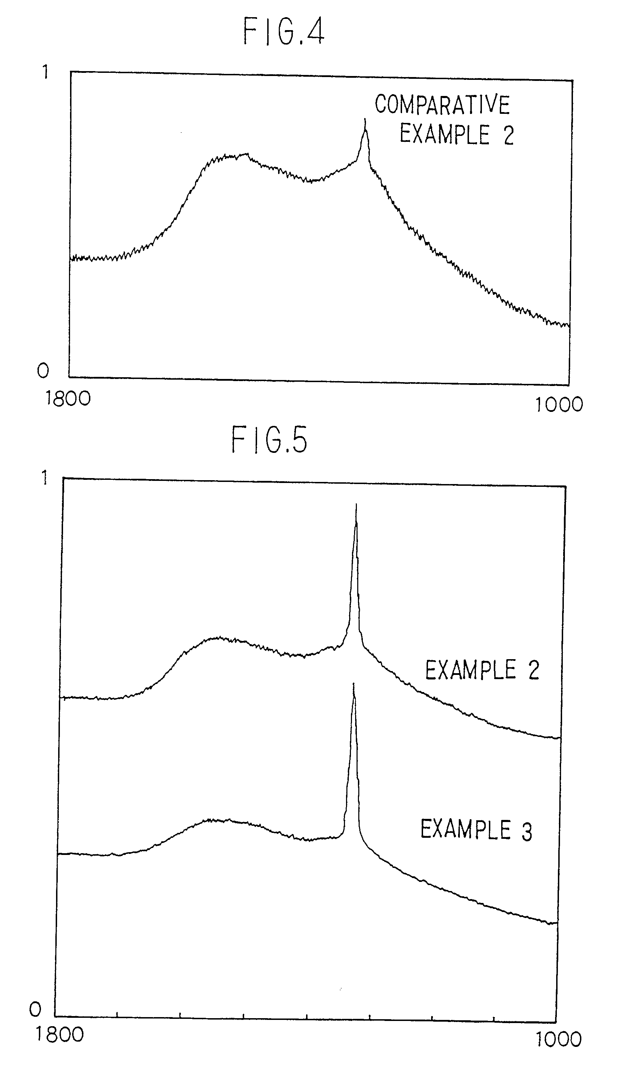

Diamond was produced following the procedures of Example 1 except that the starting gas volume ratio of $CO:H_2$ was changed to 50:50 and that a $CO_2/CO$ ratio was changed to 1.25 Vol.% and 2.5 Vol.%, respectively. Each Raman spectrum obtained in these examples is shown in Fig. 5.

EXAMPLE 4

Diamond was produced following the procedures of Example 1 except that the starting gas volume ratio of $CO:H_2$ was changed to 60:40 and that a $CO_2/CO$ ratio was changed to 1.0 Vol.%. The thickness of the resultant film was 18 micrometers.

EXPERIMENT

Further, cutting tests were performed using coated cutting tools obtained in Examples 1 and 4, Comparative Examples 1 and 2, and Reference Example 1. The cutting conditions were as follows.

1. Cutting method: Consecutive cutting in a longitudinal and peripheral direction (Dry cutting)
2. Material to be cut: Aluminum Alloy (AC8A)
3. Cutting conditions:
    (a) Cutting Speed: 600 m/min.
    (b) Feed Rate: 0.1 mm.rev.
    (c) Depth of Cut: 0.25 mm

In the case of Example 1, the surface of the material to be cut had metal-like gloss, and the cutting edge of the coated tool was scarcely worn. In the case of Comparative Examples 1 and 2, and Reference Example 1, the surface of the material to be cut was whitened and brightened; the material to be cut was partly melted and deposited to the edge of the cutting tool; and the surface roughness had no regularity. In Example 4, the surface of the material to be cut had metal-like gloss, and the edge of the coating tool was scarcely worn. The results of Example 4 were better than those of Example 1.

The results of the tests are as shown in Table 2.

Table 2

| Example No. | Length of Cut (m) | Roughness of Surface ($\mu$m) |
|---|---|---|
| Example 1 | 50,000* | 3.3 |
| Comp. Ex. 1 | 3,000 | 8.9 |
| Comp. Ex. 2 | 30,000 | 8.3 |
| Ref. Ex. 1 | 10,000 | 8.1 |
| Example 4 | 50,000 | 3.2 |

"*" means that the test was stopped when the length of cut reached 50,000 m and no abnormal change such as coming off was observed.

Another embodiment of the present invention is a process for consecutively synthesizing diamond on a plurality of substrates without opening the reaction system. Also, the present invention relates to a diamond synthesis apparatus which can be used in such a process. The process and apparatus will be described below.

First, one of the embodiments of the apparatus will be described.

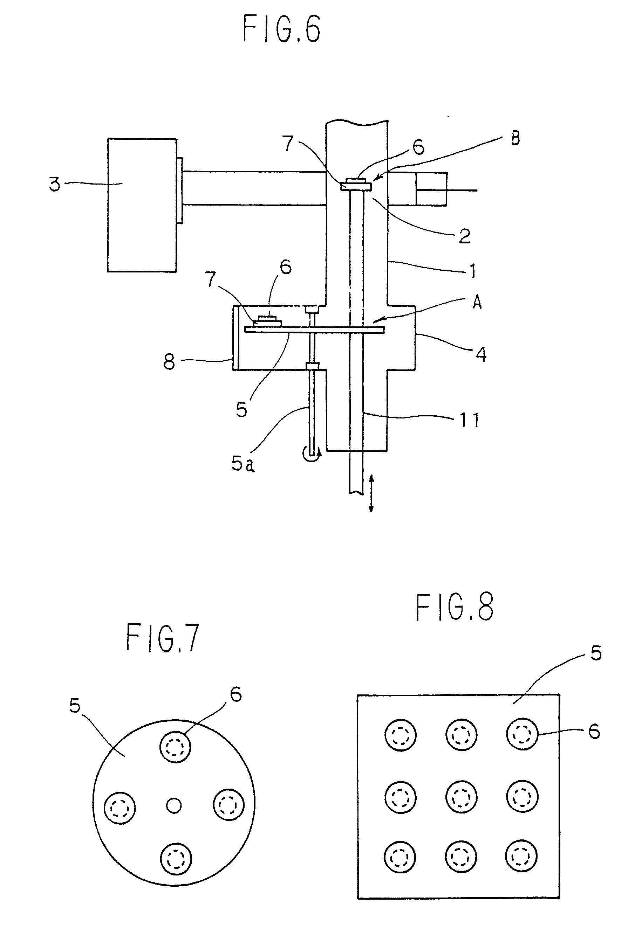

Fig. 6 is a schematic view of the diamond synthesis apparatus (microwave-plasma CVD apparatus); and Fig. 7 is a top plan view of the substrate support holder of the apparatus of Fig. 6.

In Fig. 6, a reaction tube 1 comprises a reaction section 2 for conducting diamond synthesis. A microwave oscillator 3 is positioned parallel to the reaction section in such a manner that it can irradiate microwave through a waveguide tube to the reaction section 2.

A pre-chamber 4 is in communication with the reaction tube 1, and the pressure inside of the pre-chamber 4 is kept to the same pressure as that inside of the reaction tube 1 by means of a exhausting system (not shown).

A substrate support holder 5 can support or hold a plurality of substrates 6. Substrates 6 are, in general, placed on the substrate support holder 5 through substrate supports 7. Usually, only one substrate 6 is placed on the substrate support 7, but it is possible to place a plurality of substrates 6 on the support 7.

The substrate support holder 5 is in the shape of disc. A part of the substrate support holder 5 can be turned to be moved to a predetermined location in the reaction tube 1 by means of a rotation of a rotation axis 5a in the direction of arrow shown in Fig. 6, which is rotated by a drive means (not shown). In this way, the substrates 6 positioned on the substrate support holder 5 are moved to a predetermined location from one to another.

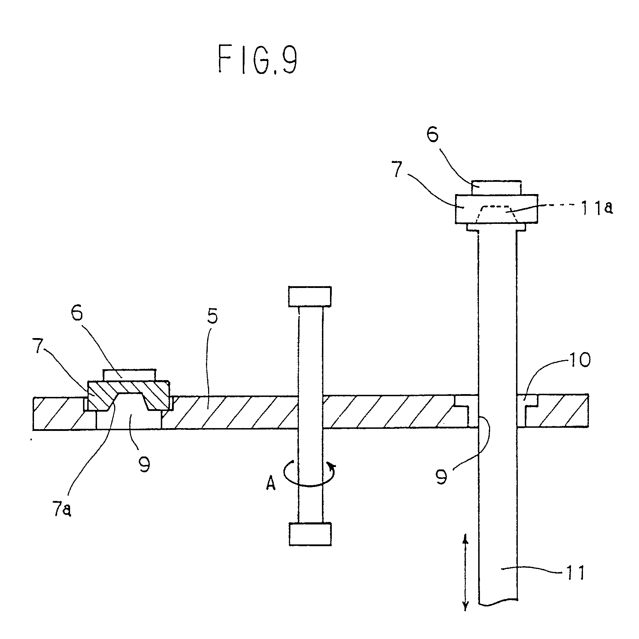

Further, the substrate support holder 5 holds the supports 7 at 90 degree interval, and thus holds the substrates 6 in the same way. The substrate support holder 5 has holes 9 which are bigger than the diameter of a moving means (support stick) described below and smaller than the supports 7. As shown in Fig. 9, these holes 9 are positioned at a place corresponding to the location of each of the support 7. Further, the peripheral portion adjacent to the hole 9 has recess 10 so as to have the supports 7 fixedly mounted on the support 7.

In addition, the substrates 6 or the supports 7 supporting the substrates 6 are supplied from an installing section 8 formed in the pre-chamber 4 to the substrate support holder 5.

The moving means 11 is in the shape of stick, and has a projection 11a, at the edge thereof, which engages a recess 7a formed at the bottom of the support 7. The moving means 11 is vertically movable within the reaction tube 1 by means of a drive means (not shown) so that it can move the substrate 6 between a predetermined position A and a predetermined position B where the synthesis takes place.

Next, a process for synthesizing diamond utilising the apparatus having the above structures, will be described below.

First, from the installing section 8, a plurality of supports 7 supporting substrates 6 are moved and placed on the substrate support holder 5. After the section 8 has been closed, the pressure inside of the reaction tube 1 and the reaction section 4 is reduced to a predetermined pressure by means of the exhausting system (not shown).

One of the substrates 6 is moved to the predetermined position A in the reaction section by a rotation of the substrate support holder 5. Then, the moving means 11 is raised to move the support 7 with the substrate 6 to the synthesis position B in the reaction tube 1. Then, diamond is synthesized on the substrate 6. The synthesis conditions may be appropriately determined as previously described.

After the reaction, the moving means 11 is lowered to return the support 7 with the substrate 6 thereon to the substrate support holder 5. Then, the substrate support holder 5 is rotated by the angle of 90°, and at the same time, the next substrate 6 is moved to the predetermined position A in the reaction section.

The consecutive diamond synthesis on a plurality of the substrates can be performed by repeating the above procedures.

In this case, if the above procedures can be performed as sequential operation at an interval corresponding to the predetermined diamond synthesis time using a timer or the like, it is possible to completely automate the consecutive diamond synthesis on a plurality of the substrates.

In addition, it is preferable to keep the reaction conditions in the reaction section unchanged during the synthesis and also when the substrates 6 in the pre-chamber are moved to the synthesis position B. That is, it is preferable that the synthesis conditions such as a gas flow rate and plasma output be kept unchanged, provided that the pressure can be reduced from the reaction pressure (in general, 40 Torr) to about 10 Torr, when the substrate 6 is moved between the position A and the position B. It is desired to reduce the pressure in this way to keep the plasma generated.

The diamond synthesis apparatus of the present invention is not limited to the above embodiment. For example, as shown in Fig. 8, the substrate support holder 5 can be formed into the square shape; the substrates are positioned lengthwise and breadthwise; and the substrates 6 can be moved to a predetermined position by sliding the substrate support holder 5 in a horizontal direction.

Further, it is possible to use a substrate support holder 5 having U-shaped cuts in stead of holes made in the peripheral portion of the substrate support holder 5 as shown in Fig. 7. In this case, the placing and displacing of the substrates may become easy.

The number of the substrates 6 (supports 7) to be placed in the pre-chamber is not limited to four or nine, but can be any desired number.

The means for moving the substrate 6 to the predetermined position A, and the means for moving the substrate 6 between the position A and the synthesis position B are not limited to the above embodiments, but can be selected from any known conveying means. The known conveying means include, for example, a means using a robot arm and a means using a belt-conveyer movable in a vertical direction.

The above-mentioned process or apparatus for consecutively synthesizing diamond or diamond-like carbon on a plurality of substrates are not limited to a microwave-plasma method or an apparatus using such method, but can be applicable to any diamond synthesis in the gas phase.

This invention will be further described with reference to non-limitative Example 5.


EXAMPLE 5


The diamond synthesis apparatus as shown in Fig. 6 was used in this example. Each of four silicon nitride type cutting tool tips (substrates) were placed on each support which was mounted on the substrate support holder as shown in Fig. 7. Then, the installing section was closed and the pre-chamber and the reaction section were evacuated. By way of the supporting stick (moving means), one of the substrate supports with the tool tips thereon was moved to the reaction position in the reaction section.

Then, the diamond was formed on the tool tip using the following synthesis conditions:

| Starting Gas: | Components | CO | 15 Vol.% |
| | | $H_2$ | 85 Vol.% |
| Mixed Gas Flow Rate: | 100 SCCM | | |
| Surface Temperature: | 970°C | | |
| Reaction Pressure: | 40 Torr | | |
| Microwave Output: | 350 W (Frequency: 2.45 GHz) | | |
| Reaction Time: | 5 hours. | | |

After the reaction, while the synthesis conditions were kept unchanged except for the reduction in the reaction pressure to 10 Torr by means of a pressure reducing device, the support stick was lowered to return the substrate holder to the substrate support holder. The holder was rotated by the degree of 90° to move the second substrate support to the reaction section. The second substrate support was moved to the synthesis position by means of the support stick. And then, the pressure was resumed to 40 Torr and the diamond synthesis was carried out in the same manner as above. These procedures were repeated to obtain four diamond coated tool tips.

In addition, the above procedures were completely automated by setting the synthesis time as 5 hours.

8

The time spent to move each substrate was just one minute.

The thickness of the obtained diamond film coated on the tips was 10 micrometers. The processing time in total from placing to displacing of the substrates was about 22 hours. Thus, the processing time was reduced as compared to the processing time of 28 hours in the case of using a conventional batch synthesis apparatus. The results of the tests showed excellent performance of the resultant products. For example, the obtained tool tips had extended life time and gave better surface treatment. The melt-deposition of a material to be treated was not found.

In addition, the same procedures were followed using ten substrate support holders with the substrate supports thereon. Also, ten diamond coated substrates having uniform quality were obtained.

## Claims

1. A process for synthesizing diamond in a gas phase using carbon monoxide and hydrogen gas as starting gases, which comprises adding an oxygen-containing inorganic gas other than carbon monoxide to the starting gases and conducting synthesis of diamond under conditions where graphite is produced unless the oxygen-containing inorganic gas is added.

2. A process according to Claim 1 wherein the diamond synthesis is carried out under conditions where a substrate temperature is calculated from the following equation:

The substrate temperature $\geq [1000 - (CO\%) \times 1.3]°C$ and a carbon monoxide content is at least 10 volume percent based on the total amount of the starting gases.

3. A process according to Claim 1 wherein the oxygen-containing inorganic gas is carbon dioxide.

4. A process according to Claim 3 wherein the carbon dioxide is added in amount of 0.2 to 10 Vol. percent based on the amount of carbon monoxide.

5. A process for synthesizing diamond which comprises placing a plurality of substrates in a pre-chamber which is in communication with a reaction section, moving each of the substrates to the reaction section, synthesizing diamond on the substrate and then returning the substrate with synthesized diamond formed thereon to the pre-chamber.

6. A process according to Claim 5 wherein a gas flow rate and plasma output are kept substantially unchanged during the diamond synthesis.

7. A process according to Claim 5 wherein a gas pressure is kept substantially unchanged during the diamond synthesis, provided that only during the substrate exchange period the gas pressure is decreased in order to keep plasma discharge.

8. A diamond synthesis apparatus comprising a reaction section, a pre-chamber which is in communication with the reaction section, a substrate holding section disposed in the pre-chamber for placing a plurality of substrates thereon and moving the substrates to a predetermined position from one to another, a means for moving each of the substrates between the predetermined position in the pre-chamber and a synthesis reaction position in the reaction section.

9. An apparatus according to Claim 8 wherein the substrate holding section includes a substrate support for supporting the substrate thereon, and a disc-like substrate support holder which is rotatable and capable of determining the position of the substrates.

10. An apparatus according to claim 8 and 9 which is a microwave plasma apparatus.

# FIG.1

# FIG.2

EXAMPLE 1

# FIG.3

COMPARATIVE
EXAMPLE 1

# FIG.4

COMPARATIVE
EXAMPLE 2

1

0

1800                    1000

# FIG.5

1

EXAMPLE 2

EXAMPLE 3

0

1800                    1000

# FIG.6

# FIG.7

# FIG.8

# FIG.9